# EUROPÄISCHE PATENTSCHRIFT

(11) **EP 2 012 359 B1**
(45) Veröffentlichungstag und Bekanntmachung des Hinweises auf die Patenterteilung: **06.07.2016**
(21) Anmeldenummer: 08167292.5
(22) Anmeldetag: 10.12.2002
(51) Int. Cl.: H01L 27/115, H01L 21/8247

(54) **Nichtflüchtige Zweitransistor-Halbleiterspeicherzelle sowie zugehöriges Herstellungsverfahren**
Non-volatile two-transistor semiconductor memory cell and method for producing the same
Cellule de mémoire non volatile à semi-conducteurs à deux transistors, et procédé de fabrication correspondant

(30) Priorität: 15.01.2002 DE 10201303
(43) Veröffentlichungstag der Anmeldung: 07.01.2009
(62) Teilanmeldung aus: 02791620.4
(73) Patentinhaber: Infineon Technologies AG, 85579 Neubiberg (DE)
(72) Erfinder: Schuler, Franz, 85586, Poing (DE); Tempel, Georg, 01277, Dresden (DE)
(74) Vertreter: Kindermann, Peter

(56) Entgegenhaltungen:
- EP-A- 1 102 319
- US-A- 6 140 688
- US-A1- 2001 044 183
- US-B1- 6 184 093
- US-B1- 6 316 317

## Beschreibung

Die vorliegende Erfindung bezieht sich auf eine nichtflüchtige Zweitransistor-Halbleiterspeicherzelle sowie ein zugehöriges Verfahren zu deren Herstellung und insbesondere auf eine nichtflüchtige Halbleiterspeicherzelle mit einem Speichertransistor und einem damit verbundenen Auswahltransistor mit Metall-Gates.

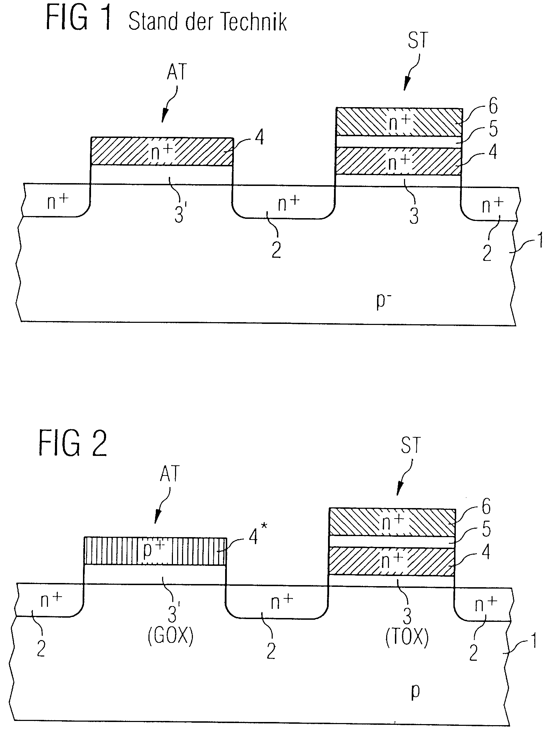

Figur 1 zeigt eine vereinfachte Schnittansicht einer herkömmlichen nichtflüchtigen Zweitransistor-Halbleiterspeicherzelle, wobei in einem Halbleitersubstrat 1, welches beispielsweise p⁻-dotiert ist, ein Auswahltransistor AT sowie ein Speichertransistor ST ausgebildet und über ein gemeinsames Source-/Draingebiet 2 miteinander verbunden sind.

Der Speichertransistor ST besteht üblicherweise aus einer isolierenden Tunneloxidschicht 3, einer leitenden Floating-Gate-Schicht 4, einer isolierenden dielektrischen Schicht 5 und einer leitenden Steuer-Gate-Schicht 6. Zur Speicherung von Informationen werden Ladungen vom Halbleitersubstrat 1 in die Floating-Gate-Schicht 4 eingebracht. Verfahren zum Einbringen der Ladungen in die Floating-Gate-Schicht 4 sind beispielsweise Injektion heißer Ladungsträger und Fowler-Nordheim-Tunneln.

Zum Auswählen bzw. Ansteuern des eigentlichen Speichertransistors ST besitzt die Zweitransistor-Halbleiterspeicherzelle ferner einen Auswahltransistor AT, der als Feldeffekttransistor im Wesentlichen eine Gateoxidschicht 3' und eine darüber liegende Steuer-Gate-Schicht 4 aufweist. Die Floating-Gate-Schicht des Speichertransistors und die Steuer-Gate-Schicht des Auswahltransistors bestehen üblicherweise aus dem gleichen Material wie z.B. Polysilizium, welches beispielsweise n⁺-dotiert ist.

Bei derartigen nichtflüchtigen Zweitransistor-Halbleiterspeicherzellen sind insbesondere die Ladungshalteeigenschaften für den Einsatz und die Zuverlässigkeit von großer Bedeutung. Diese Ladungshalteeigenschaften sind üblicherweise durch (anomalen) Ladungsverlust begrenzt, der sich auf Grund von Leckphänomenen ergibt. Dieser Ladungsverlust geschieht beispielsweise auf Grund von Traps bzw. Störstellen innerhalb des Tunneloxids 3, wobei ein Tunnelmechanismus durch diese Störstellen bzw. Traps unterstützt wird (trap assisted tunneling). Zur Vermeidung von derartigen Leckströmen bzw. zur Verbesserung der Ladungshalteeigenschaften werden üblicherweise die Schichtdicken für die Tunneloxidschicht 3 und/oder die dielektrische Schicht 5 erhöht, wodurch sich jedoch die elektrischen Eigenschaften der Speicherzelle verschlechtern und insbesondere die Betriebsspannungen zum Lesen, Schreiben und/oder Löschen der Speicherzelle angehoben werden müssen. Die Druckschrift US 6 140 688 A offenbart einen MOS-Transistor sowie ein zugehöriges Herstellungsverfahren, wobei ein Metall-Gate selbstjustierend ausgebildet wird, um eine erhöhte Elektronen-Speicherkapazität zu erhalten.

Aus der Druckschrift EP 1 102 319 A1 ist ferner eine nichtflüchtige Zweitransistor-Halbleiterspeicherzelle mit einem Speichertransistor und einem Auswahltransistor bekannt. Die Auswahltransistor-Steuerschicht und die Ladungsspeicherschicht werden hierbei in unterschiedlichen Schritten aus Halbleitermaterial ausgebildet. Der Auswahl- und Speichertransistor liegt hierbei in einer gemeinsamen p-Wanne, welche sich in einem Substrat befindet. Ferner ist aus dieser Druckschrift bekannt, einen Hochvolt-Transistor mit hoher Schwellwertspannung dadurch zu schaffen, dass sein Gate vom gleichen Leitungstyp ist wie das Substrat.

Weiterhin ist aus der Druckschrift US 6 184 093 B1 eine nichtflüchtige Zweitransistor-Halbleiterspeicherzelle sowie ein zugehöriges Herstellungsverfahren bekannt, wobei der Speichertransistor eine dünne Isolationsschicht und der Auswahltransistor eine dicke Isolationsschicht aufweist. Für derartige unterschiedlich dicke Isolationsschichten schlägt die Druckschrift jedoch die Verwendung von sogenannten Programmier- und Lösch-Implantationsgebieten vor, welche gemeinsam und unterhalb der dünnen Isolationsschicht ausgebildet sind.

Eine Schwellwertanpassung für Auswahl- und Speichertransistoren ist grundsätzlich aus der Druckschrift US 6 316 317 B1 bekannt, wobei jedoch die Dicke der Isolationsschicht im Auswahltransistor kleiner als die Dicke der Isolationsschicht im Speichertransistor ist.

Schließlich ist aus der den Oberbegriff des Patentanspruchs 1 bildenden Druckschrift US 2001/044183 A1 eine nichtflüchtige Zweitransistor-Halbleiterspeicherzelle sowie ein zugehöriges Herstellungsverfahren bekannt, bei dem ein Speichertransistor und ein Auswahltransistor mit jeweils einem Sourcegebiet, einem Draingebiet und einem Kanalgebiet in einem Substrat ausgebildet sind.

Der Erfindung liegt daher die Aufgabe zu Grunde eine nichtflüchtige Zweitransistor-Halbleiterspeicherzelle sowie ein zugehöriges Herstellungsverfahren zu schaffen, welche verbesserte elektrische Eigenschaften und insbesondere verbesserte Ladungshalteeigenschaften aufweist.

Erfindungsgemäß wird diese Aufgabe hinsichtlich der Speicherzelle durch die Merkmale des Patentanspruchs 1 und hinsichtlich des Verfahrens durch die Maßnahmen des Patentanspruchs 6 gelöst.

Insbesondere durch die unterschiedlichen metallischen Materialien der Ladungsspeicherschicht im Speichertransistor und der Auswahltransistor-Steuerschicht im Auswahltransistor zur unabhängigen Optimierung der zugehörigen Schwellwertspannungen, kann ohne Verschlechterung der elektrischen Eigenschaften der Speicherzelle eine Verbesserung der Ladungshalteeigenschaften im Speichertransistor realisiert werden.

Vorzugsweise wird eine Dotierung des Halbleitersubstrats bzw. der Wannen derart erhöht, dass die Schwellwertspannung einer Auswerteschaltung mit der Schwellwertspannung des Speichertransistors im ungeladenen Zustand zusammenfällt. Dadurch können die elektrischen Felder im Speichertransistor und damit ein auf (z.B. durch Störstellen (traps) verursachtes) Tunneln basierender Leckstrom verringert werden, da dieser Tunnelstrom exponentiell abhängig vom elektrischen Feld ist. Andererseits wird die sich daraus ergebende Einsatzspannungsverschiebung durch eine Anpassung der der Austrittsarbeiten in der Auswahltransistor-Steuerschicht durch eine entsprechende Metallauswahl kompensiert, wodurch die absolute Schwellwertspannung des Auswahltransistors AT reduziert wird und damit der Lesestrom durch die gesamte Zelle erhöht wird. Dies wiederum erlaubt einfachere Auswerteschaltungen auf dem Chip.

Hinsichtlich des Verfahrens werden vorzugsweise sowohl für den Auswahltransistor als auch den Speichertransistor eine erste Isolationsschicht, eine jeweilige Metallschicht, eine zweite Isolationsschicht und eine weitere elektrisch leitende Schicht ausgebildet und derart strukturiert, dass sich die beiden Transistoren mit dazwischen liegenden Source- und Draingebieten im Halbleitersubstrat ergeben. Eine Dotierung des Halbleitersubstrats wird hierbei derart angehoben, dass die Schwellwertspannung einer Auswerteschaltung mit der Schwellwertspannung des Speichertransistors im ungeladenen Zustand zusammenfällt. Lediglich für die Metallschicht des Auswahltransistors ist hierbei ein geeignetes und zur Metallschicht des Speichertransistors unterschiedliches Material anzuwenden, um die Schwellwertspannung zu verringern. Auf diese Weise kann eine nichtflüchtige Zweitransistor-Halbleiterspeicherzelle mit verbesserten Ladungshalteeigenschaften besonders kostengünstig hergestellt werden.

In den weiteren Unteransprüchen sind weitere vorteilhafte Ausgestaltungen der Erfindung gekennzeichnet.

Die Erfindung wird nachstehend anhand eines Ausführungsbeispiels unter Bezugnahme auf die Zeichnung näher beschrieben.

Es zeigen:
Figur 1 eine vereinfachte Schnittansicht einer herkömmlichen nichtflüchtigen Zweitransistor-Halbleiterspeicherzelle;
Figur 2 eine vereinfachte Schnittansicht einer nicht beanspruchten beispielhaften nichtflüchtigen Zweitransistor-Halbleiterspeicherzelle;
Figuren 3A bis 3D vereinfachte Schnittansichten zur Veranschaulichung wesentlicher Herstellungsschritte einer nicht beanspruchten beispielhaften nichtflüchtigen Zweitransistor-Halbleiterspeicherzelle;
Figur 4a und 4B vereinfachte graphische Darstellungen zur Veranschaulichung einer Abhängigkeit der Schwellwertspannungen von der Zeit aufgrund von Ladungsverlusten; und
Figuren 5A bis 5C vereinfachte graphische Darstellungen zur Veranschaulichung der Auswirkungen einer Änderung der Austrittsarbeit auf die Schwellwertspannungen im Auswahltransistor und Speichertransistor.

Figur 2 zeigt eine vereinfachte Schnittansicht einer nichtflüchtigen Zweitransistor-Halbleiterspeicherzelle gemäß eines nicht beanspruchten Beispiels, wobei gleiche Bezugszeichen gleiche oder ähnliche Schichten bezeichnen wie in Figur 1.

Gemäß Figur 2 wird in einem Substrat 1, welches beispielsweise aus einem p-dotierten Silizium-Halbleitermaterial besteht, ein Auswahltransistor AT und ein Speichertransistor ST ausgebildet, welche über ein gemeinsames Source-/Draingebiet 2 miteinander verbunden sind. Der Speichertransistor ST besitzt eine erste Speichertransistor-Isolationsschicht 3, die vorzugsweise eine Tunneloxidschicht TOX aufweist und ca. 10 nm dick ist. An der Oberfläche dieser ersten Speichertransistor-Isolationsschicht 3, die beispielsweise aus einer thermisch ausgebildeten SiO₂-Schicht besteht befindet sich eine Ladungsspeicherschicht 4, die beispielsweise eine erste Metallschicht aufweist. Darüber liegend ist eine zweite Speichertransistor-Isolationsschicht 5 angeordnet, die die Ladungsspeicherschicht 4 von einer darüber angeordneten Speichertransistor-Steuerschicht 6 isoliert. Die Speichertransistor-Steuerschicht 6 kann beispielsweise n⁺-dotiertes Polysilizium aufweisen und stellt im Wesentlichen eine Wortleitung der Speicherzelle dar. Die zweite Speichertransistor-Isolationsschicht 5 wird auch als Interpoly-Dielektrikum bezeichnet und kann beispielsweise eine ONO-Schichtenfolge (Oxid-Nitrid-Oxid) aufweisen.

Der Auswahltransistor AT besteht seinerseits aus einer an der Oberfläche des Substrats 1 bzw. zwischen den Source- und Draingebieten 2 liegenden Kanalgebiets ersten Auswahltransistor-Isolationsschicht 3' und einer Auswahltransistor-Steuerschicht 4*. Die Auswahltransistor-Isolationsschicht 3' besteht vorzugsweise aus einer Gateoxidschicht GOX. Die Auswahltransistor-Steuerschicht 4* besteht ebenfalls aus einer elektrisch leitenden Schicht und beispielsweise aus einer zweiten Metallschicht.

Der wesentliche Unterschied der erfindungsgemäßen Speicherzelle ergibt sich nunmehr aus der modifizierten Dotierung des Substrates und der sich daraus ergebenden modifizierten natürlichen Einsatzspannungen in Kombination mit der Wahl unterschiedlicher Materialien fuer die Ladungsspeicherschicht 4 und die Auswahltransistor-Steuerschicht 4*. Auf Grund einer erhöhten Dotierung des Substrats 1 von p⁻ beispielsweise auf p oder p⁺ bei gleichbleibender Dotierung für die Speichertransistor-Steuerschicht 6 erhält man eine erhöhte Schwellwertspannung des Speichertransistors ST. Wie später im Einzelnen beschrieben wird, ergibt sich durch diese Anpassung der Schwellenwertspannung im Speichertransistor ST die Möglichkeit, die Ladungshalteeigenschaften zu optimieren. Andererseits erhält man im Auswahltransistor AT eine Verringerung der Schwellwertspannung durch ein zur Ladungsspeicherschicht 4 unterschiedlichen metallischen Materials. Genauer gesagt wird durch das metallische Material der Auswahltransistor-Steuerschicht 4* die Erhöhung dessen Schwellwertspannung kompensiert, wodurch sich im Wesentlichen eine erniedrigte Schwellwertspannung im Auswahltransistor ergibt und somit eine nicht dargestellte Auswerteschaltung zum Auswerten der Speicherzelle einfacher verwirklicht werden kann.

Wesentlich für das vorliegende Konzept ist demnach, dass im Speichertransistor ST die Schwellwertspannung ueber die Substrat-, Wannen- und/oder Kanaldotierung bzgl. Ladungshaltung optimiert werden kann und dass die sich dadurch fuer den Auswahltransistor ergebenden Nachteile durch eine zur Ladungsspeicherschicht unterschiedliche Metallmaterialverwendung kompensiert werden können. Dadurch können die für das Tunneln verantwortlichen elektrischen Felder im Speichertransistor verringert werden, wodurch sich eine verbesserte Ladungshalteeigenschaft ergibt, wobei hinsichtlich einer Außenbeschaltung die elektrischen Eigenschaften der Zelle unverändert bleiben, da im Auswahltransistor AT diese Schwellwertverschiebung wieder kompensiert wird.

Erfindungsgemäß erhält man den Kompensationseffekt somit durch Einsatz von unterschiedlichen Materialien und insbesondere unterschiedlicher Metalle für die Ladungsspeicherschicht 4 und die Auswahltransistor-Steuerschicht 4*.

Eine genaue Erläuterung der vorstehend beschriebenen Zusammenhänge erfolgt nachstehend, wobei jedoch zunächst ein mögliches Verfahren zur Herstellung einer nicht beanspruchten nichtflüchtigen Zweitransistor-Halbleiterspeicherzelle beschrieben wird.

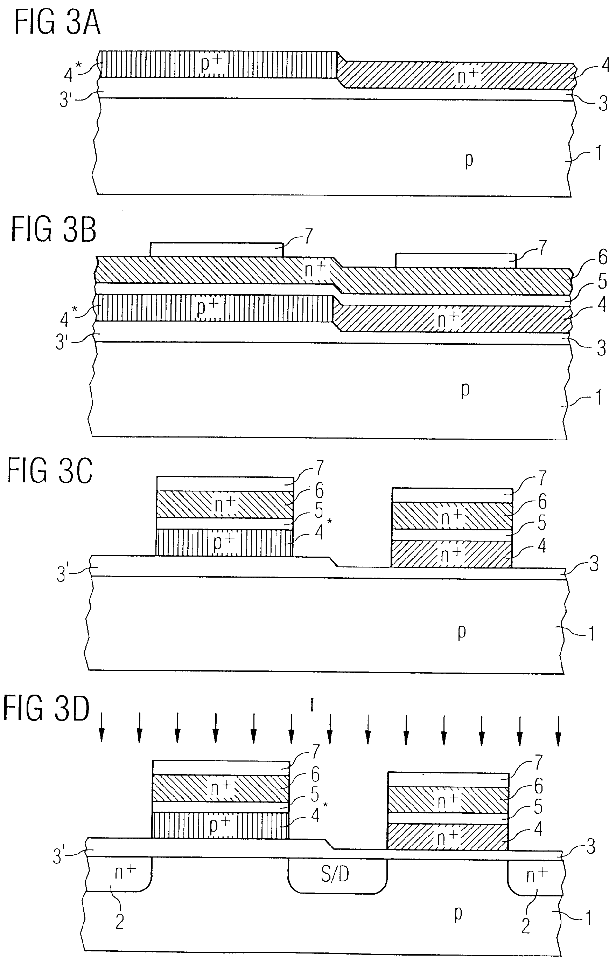

Figuren 3A bis 3D zeigen vereinfachte Schnittansichten zur Veranschaulichung wesentlicher Herstellungsschritte einer nicht beanspruchten beispielhaften nichtflüchtigen Zweitransistor-Halbleiterspeicherzelle, wobei gleiche Bezugszeichen gleiche oder ähnliche Schichten bezeichnen und auf eine wiederholte Beschreibung nachfolgend verzichtet wird.

Gemäß Figur 3A wird zunächst auf einem Substrat 1, welches beispielsweise ein Silizium-Halbleitersubstrat mit einer erhöhten p-Dotierung aufweist eine erste Isolationsschicht 3 sowohl in einem Auswahltransistor-Bereich als auch in einem Speichertransistor-Bereich ausgebildet. Diese erste Isolationsschicht 3 bzw. 3' besteht beispielsweise aus einem thermisch ausgebildeten Siliziumdioxid. Ein positiver Effekt einer ausreichend dicken ersten Isolationsschicht bzw. Gateoxidschicht 3' im Auswahltransistor-Bereich ist die Vermeidung einer Dotierstoff- beispielsweise Bor-Penetration in das Substrat 1, die sich aus einer nachfolgenden Dotierung ergeben kann.

Nachfolgend wird an der Oberfläche eine erste und zweite Metallschicht 4* bzw. 4 ausgebildet. Auf diese Weise werden bereits die vorstehend beschriebenen Einsatzspannungen bzw. Schwellwertspannungen in den verschiedenen Bereichen unterschiedlich eingestellt, wobei vorzugsweise eine Schwellwertspannung im Auswahltransistor-Bereich derart eingestellt ist, dass sich kein Unterschied zum Auswahltransistor einer herkömmlichen nichtflüchtigen Zweitransistor-Halbleiterspeicherzelle ergibt, wodurch z.B. bereits existierende Auswerteschaltungen bzw. -konzepte problemlos übernommen werden können.

Gemäß Figur 3B wird in einem nachfolgenden Schritt eine zweite Isolationsschicht 5 an der Oberfläche der ersten und zweiten Metallschicht 4* bzw. 4 ausgebildet, wobei diese zumindest im Speichertransistor-Bereich ausgebildet werden muss.

Diese zweite Isolationsschicht 5 wird üblicherweise als Inter-Poly-Dielektrikum bezeichnet und kann beispielsweise eine ONO-Schichtenfolge aufweisen, wodurch sich besonders gute Isolationseigenschaften bei guter kapazativer Ankopplung realisieren lassen und insbesondere Leckströme zu einer nachfolgend ausgebildeten weiteren elektrisch leitenden Schicht 6 verhindert werden. Die weitere elektrisch leitende Schicht 6 besteht beispielsweise aus einer n⁺-dotierten Polysilizium-schicht, die mit einem herkömmlichen Verfahren abgeschieden oder aufgewachst wird.

Abschließend wird eine Maskenschicht 7 an der Oberfläche von zumindest der weiteren elektrisch leitenden Schicht 6 im Speichertransistor-Bereich ST und der elektrisch leitenden Halbleiterschicht im Auswahltransistor-Bereich AT ausgebildet und strukturiert, wobei beispielsweise eine herkömmliche Hartmaskenschicht verwendet werden kann.

Gemäß Figur 3C wird nunmehr unter Verwendung der strukturierten Maskenschicht 7 zunächst die weitere elektrisch leitende Schicht 6 teilweise entfernt, wodurch man zunächst die Wortleitungen der Speichertransistoren ST und darüber hinaus durch weiteres Entfernen der Schichten bis zur ersten und zweiten Metallschicht 4* bzw. 4 auch die Leitungen der Auswahlgates der Auswahltransistoren erhält. Zum Entfernen dieser Schichten 4 bzw. 4*, 5 und 6 kann ein jeweils verfügbares Standardätzverfahren verwendet werden, wobei insbesondere anisotrope Ätzverfahren in Betracht kommen, die selektiv zur ersten Isolationsschicht 3, 3' und zur Maskenschicht 7 wirken.

Gemäß Figur 3D wird in einem abschließenden Herstellungsschritt eine selbstjustierende Implantation I zur Realisierung der Source-/Draingebiete 2 durchgeführt, wobei zur Herstellung eines NMOS-Transistors eine n⁺-Dotierung beispielsweise mittels Phosphor oder Arsen erfolgt. Weitere Herstellungsschritte zu Fertigstellung der Zweitransistor-Halbleiterspeicherzelle werden nachfolgend nicht beschrieben, da sie allgemein bekannt sind.

Die für den Auswahltransistor AT nicht benötigten Schichten 5, 6 und 7 bleiben hierbei unbeschaltet oder können in einem nachfolgenden Verfahrensschritt entfernt werden. Auf diese Weise erhält man eine nichtflüchtige Zweitransistor-Halbleiterspeicherzelle mit verbesserten Ladungshalteeigenschaften, die auf besonders einfache Art und Weise hergestellt werden kann.

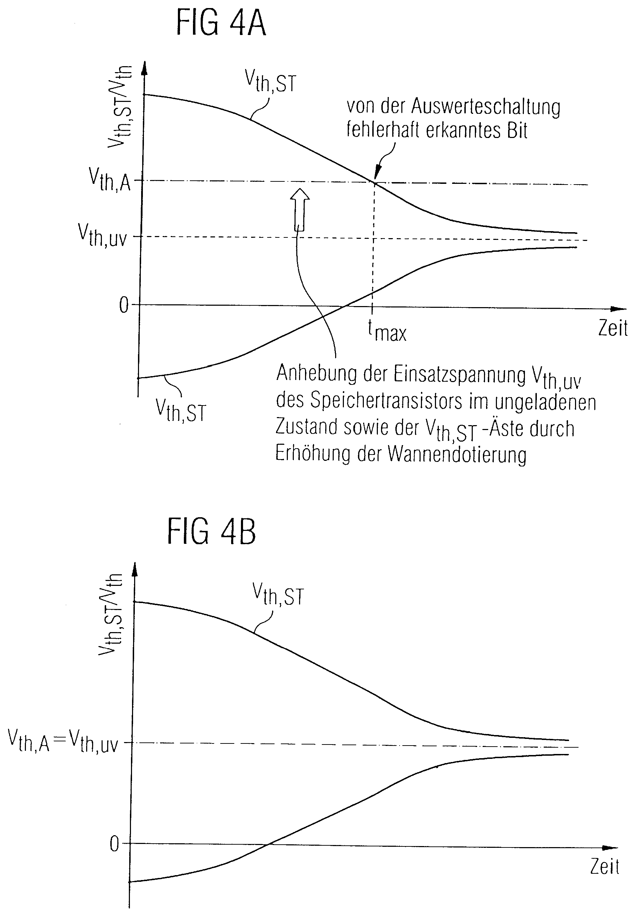

Zur Veranschaulichung der Wirkungsweise der erfindungsgemäßen Speicherzelle werden anhand von Figuren 4A und 4B die Einflüsse einer Schwellwertspannung im Speichertransistor auf die Ladungshalteeigenschaften beschrieben.

Figur 4A zeigt eine graphische Darstellung der in einer Speicherzelle maßgeblichen Schwellwertspannungen und ihre zeitliche Abhängigkeit, wenn die Speicherzelle (anomale) Ladungsverlusteffekte zeigt.

Gemäß Figur 4A ist mit V_{th,UV} eine Einsatzspannung bzw. Schwellwertspannung des Speichertransistors ST in einem ungeladenen Zustand (z.B. nach einem UV-Löschen) dargestellt. Die Äste V_{th,ST} zeigen die Schwellwertspannung des Speichertransistors ST im geladenen Zustand bzw. den transienten Verlauf der Einsatzspannung bis hin zum sogenannten ungeladenen Zustand, bei dem sich in der ladungsspeichernden Schicht 4 keinerlei Ladungen befinden. Diese Entladung ergibt sich im Wesentlichen durch z.B. störstellenunterstütztes Tunneln (trap assisted tunneling) hervorgerufene Leckströme.

Mit V_{th,A} ist eine Schwellwertspannung einer üblicherweise notwendigen Auswerteschaltung für die Speicherzelle dargestellt, die mehr oder weniger hoch bzw. fein sein kann. Grundsätzlich gilt jedoch, dass eine zugehörige Auswerteschaltung besonders einfach und kostengünstig hergestellt werden kann, je höher diese Spannung V_{th,A} ist. Andererseits zeigt die Figur 4A, dass je höher diese Schwellwertspannung V_{th,A} ist, um so früher ein Zeitpunkt tₘₐₓ erreicht wird, zu dem ein abgespeichertes Bit nur noch fehlerhaft von der Auswerteschaltung erkannt wird.

Mit der vorliegenden Erfindung erfolgt nunmehr eine Anhebung der Einsatzspannung V_{th,UV} des Speichertransistors ST im ungeladenen Zustand sowie seiner zugehörigen Entladekurven V_{th,ST} durch beispielsweise die vorstehend beschriebene Erhöhung einer Substratdotierung, einer Kanalgebietdotierung, und/oder einer Wannendotierung. Als Ergebnis dieser Anhebung der Einsatzspannung V_{th,UV} erhält man die in Figur 4B dargestellte Idealkurve, wobei man eine verbesserte Ladungshalteeigenschaft erhält, da die Schwellwertspannung V_{th,A} der Auswerteschaltung mit der Schwellwertspannung V_{th,UV} des Speichertransistors zusammenfällt.

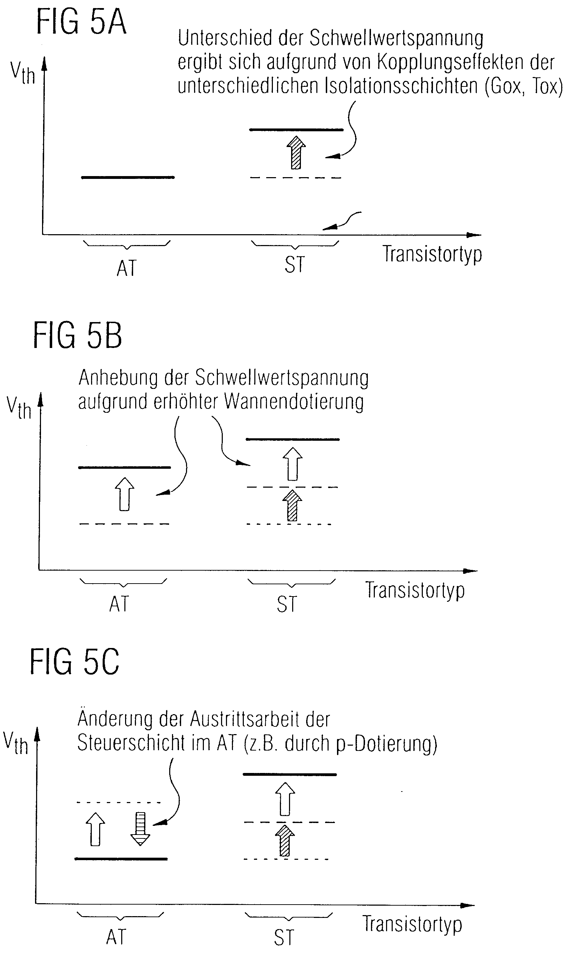

Figuren 5A bis 5C zeigen graphische Darstellungen zur weiteren Veranschaulichung der erfindungsgemäßen Schwellwertänderungen auf Grund der Änderungen der Substratdotierung bzw. der Verwendung eines unterschiedlichen Gate-Metalls für den Auswahltransistor (unterschiedliche Beschaffenheit der Metalle von Ladungsspeicherschicht 4 und Auswahltransistor-Steuerschicht 4*).

Figur 5A zeigt eine graphische Darstellung der Schwellwertspannungen Vₜₕ für einen Auswahltransistor AT und einen Speichertransistor ST, wobei sich auf Grund von Kopplungseffekten der unterschiedlichen Isolationsschichten GOX und TOX sowie der Schicht 5 in den jeweiligen Bereichen bereits ein Unterschied der jeweiligen Schwellwertspannungen ergibt. Im Regelfall besitzt der im gleichen Substrat 1 ausgebildete Speichertransistor ST einen höheren Schwellwert Vₜₕ als der zugehörige Auswahltransistor AT.

Gemäß Figur 5B wird nunmehr die Wirkung der Erhöhung der Substratdotierung beschrieben, wobei durch die erhöhte Dotierung im Substrat 1, durch eine erhöhte Wannendotierung und/oder eine erhöhte Oberflächendotierung beide Schwellwertspannungen gleichermaßen angehoben werden. Auf diese Weise erhält man zwar bereits die in Figur 4B verbesserten Ladungshalteeigenschaften im Speichertransistor ST, jedoch sind die elektrischen Eigenschaften der Speicherzelle insbesondere auf Grund der erhöhten Schwellwertspannungen im Auswahltransistor wesentlich verschlechtert.

Gemäß Figur 5C erfolgt demzufolge eine Korrektur der Schwellwertanhebung im Auswahltransistor AT, die im Wesentlichen durch eine Erhöhung der Austrittsarbeit für Elektronen in der Steuerschicht beispielsweise durch die Auswahl eines geeigneten Gate-Metalls erfolgt. Durch diese Änderung der Austrittsarbeit lediglich im Auswahltransistor AT wird demzufolge die Schwellwertspannung Vₜₕ in diesem Bereich wieder zurückgedrückt, wodurch man eine dem Ausgangszustand ähnliche Schwellwertspannung und somit ähnlich gute elektrische Eigenschaften der Speicherzelle erhält. Auf diese Weise können die Ladungshalteeigenschaften in einer Zweitransistor-Halbleiterspeicherzelle ohne Beeinflussung der elektrischen Eigenschaften oder einer notwendigen Auswerteschaltung wesentlich verbessert werden.

Die Erfindung wurde vorstehend anhand einer NMOS-Speicherzelle beschrieben. Sie ist jedoch nicht darauf beschränkt und umfasst in gleicher Weise PMOS- oder eine Kombination von PMOS- und NMOS-Zellen bzw. Transistoren. In gleicher Weise ist die Erfindung nicht auf Silizium-Halbleitermaterialien beschränkt, sondern umfasst alle weiteren Halbleitermaterialien, mit denen gezielt eine Schwellwertspannung zur Verbesserung der Ladungshalteeigenschaften verändert werden kann.
- 1: Substrat
- 2: Source-/Draingebiete
- 3, 3': erste Isolationsschicht
- 4: Ladungsspeicherschicht
- 4*: Auswahltransistor-Steuerschicht
- 5: zweite Isolationsschicht
- 6: Speichertransistor-Steuerschicht
- 7: Maskenschicht
- AT: Auswahltransistor
- ST: Speichertransistor
- V_{th,A}: Schwellwertspannung der Auswerteschaltung
- V_{th,UV}: Schwellwertspannung des Speichertransistors im ungeladenen Zustand
- V_{th,ST}: Schwellwertspannung des Speichertransistors im geladenen Zustand

## Patentansprüche

1. Nichtflüchtige Zweitransistor-Halbleiterspeicherzelle mit
einem Speichertransistor (ST) mit einer vorbestimmten Schwellwertspannung, der in einem Substrat (1) ein Source- und Draingebiet (2) mit einem dazwischen liegenden Kanalgebiet aufweist, wobei an der Oberfläche des Kanalgebiets eine erste Speichertransistor-Isolationsschicht (3), eine Ladungsspeicherschicht (4), eine zweite Speichertransistor-Isolationsschicht (5) und eine Speichertransistor-Steuerschicht (6) ausgebildet ist; und
einem Auswahltransistor (AT) mit einer vorbestimmten Schwellwertspannung, der im Substrat (1) ein Source- und Draingebiet (2) mit einem dazwischen liegenden Kanalgebiet aufweist, wobei an der Oberfläche des Kanalgebiets eine erste Auswahltransistor-Isolationsschicht (3') und eine Auswahltransistor-Steuerschicht (4*) ausgebildet ist, und wobei die erste Auswahltransistor-Isolationsschicht (3') dicker als die erste Speichertransistor-Isolationsschicht (3) ist, wodurch die Schwellwertspannungen im Auswahl- und Speichertransistor (AT, ST) unterschiedlich sind,
**dadurch gekennzeichnet, dass** die Schwellwertspannungen durch eine Substrat-/Wannendotierung derart angehoben sind, dass die Schwellwertspannung (V_{th,A}) einer Auswerteschaltung mit der Schwellwertspannung (V_{th,UV}) des Speichertransistors (ST) im ungeladenen Zustand zusammenfällt, wobei
die Auswahltransistor-Steuerschicht (4*) und die Ladungsspeicherschicht (4) jeweils eine metallische Schicht aufweisen, und wobei
zur Korrektur der Schwellwertanhebung im Auswahltransistor (AT) die Auswahltransistor-Steuerschicht (4*) eine zur Ladungsspeicherschicht (4) unterschiedliche Materialschicht aufweist.

2. Nichtflüchtige Zweitransistor-Halbleiterspeicherzelle nach Patentanspruch 1,
**dadurch gekennzeichnet, dass** das Substrat (1) ein Halbleitermaterial mit einer Dotierung vom ersten Leitungstyp (p) aufweist.

3. Nichtflüchtige Zweitransistor-Halbleiterspeicherzelle nach Patentanspruch 1 oder 2,
**dadurch gekennzeichnet, dass** eine Erhöhung der Dotierstoffkonzentration vom ersten Leitungstyp (p) im Substrat (1), den Kanalgebieten oder einem Wannengebiet erfolgt.

4. Nichtflüchtige Zweitransistor-Halbleiterspeicherzelle nach einem der Patentansprüche 1 bis 3,
**dadurch gekennzeichnet, dass** die erste Speichertransistor-Isolationsschicht (3) und die erste Auswahltransistor-Isolationsschicht (3') eine SiO₂-Schicht aufweisen.

5. Nichtflüchtige Zweitransistor-Halbleiterspeicherzelle nach einem der Patentansprüche 1 bis 4,
**dadurch gekennzeichnet, dass** der Speichertransistor (ST) und der Auswahltransistor (AT) einen NMOS- und/oder einen PMOS-Transistor darstellen.

6. Verfahren zur Herstellung einer nichtflüchtigen Zweitransistor-Halbleiterspeicherzelle mit den Schritten:
a) Ausbilden von ersten Isolationsschichten (3, 3') für einen Auswahltransistor (AT) mit einer vorbestimmten Schwellwertspannung und einen Speichertransistor (ST) mit einer vorbestimmten Schwellwertspannung auf einem Halbleitersubstrat (1), das eine Dotierung vom ersten Leitungstyp (p) aufweist, wobei die erste Auswahltransistor-Isolationsschicht (3') dicker als die erste Speichertransistor-Isolationsschicht (3) ist;
b) Ausbilden einer ersten Metallschicht (4*) an der Oberfläche der ersten Isolationsschicht (3') in einem Bereich des Auswahltransistors (AT) und einer zweiten Metallschicht (4) an der Oberfläche der ersten Isolationsschicht (3) in einem Bereich des Speichertransistors (ST);
c) Ausbilden einer zweiten Isolationsschicht (5) zumindest an der Oberfläche der zweiten Metallschicht (4) im Bereich des Speichertransistors (ST);
d) Ausbilden einer weiteren elektrisch leitenden Schicht (6) an der Oberfläche der zweiten Isolationsschicht (5) zumindest im Bereich des Speichertransistors (ST);
e) Ausbilden und Strukturieren einer Maskenschicht (7);
f) Ausbilden von Schichtstapeln im Bereich des Auswahltransistors (AT) und des Speichertransistors (ST) unter Verwendung der strukturierten Maskenschicht (7); und
g) Ausbilden von Source- und Draingebieten (2) mit einer Dotierung vom zweiten Leitungstyp (n) unter Verwendung der Schichtstapel als Maske, wobei
in Schritt a) beide Schwellwertspannungen im Auswahl- und Speichertransistor (AT, ST) unterschiedlich sind und durch eine Dotierung des Halbleitersubstrats (1) derart angehoben werden, dass die Schwellwertspannung (V_{th,A}) einer Auswerteschaltung mit der Schwellwertspannung (V_{th,UV}) des Speichertransistors (ST) im ungeladenen Zustand zusammenfällt, und wobei
in Schritt b) zur Korrektur der Schwellwertanhebung im Auswahltransistor (AT) die erste Metallschicht (4*) des Auswahltransistors (AT) ein zur zweiten Metallschicht (4) des Speichertransistors (ST) unterschiedliches Material aufweist.

7. Verfahren nach Patentanspruch 6,
**dadurch gekennzeichnet, dass** in Schritt a) die Dotierung des Halbleitersubstrat (1) eine Grunddotierung, Wannendotierung und/oder Oberflächendotierung vom ersten Leitungstyp (p) ist.

8. Verfahren nach einem der Patentansprüche 6 oder 7,
**dadurch gekennzeichnet, dass** in Schritt a) als Speichertransistor-Isolationsschicht (3) eine Tunneloxidschicht (TOX) und als Auswahltransistor-Isolationsschicht (3') eine Gateoxidschicht (GOX) ausgebildet wird.

9. Verfahren nach einem der Patentansprüche 6 bis 8,
**dadurch gekennzeichnet, dass** in Schritt c) eine ONO-Schichtenfolge ausgebildet wird.

10. Verfahren nach einem der Patentansprüche 6 bis 9,
**dadurch gekennzeichnet, dass** in Schritt d) eine Polysilizium-Schicht abgeschieden wird, die eine Dotierung vom zweiten Leitungstyp (n) aufweist.

11. Verfahren nach einem der Patentansprüche 6 bis 10,
**dadurch gekennzeichnet, dass** in Schritt e) eine Hartmaskenschicht ausgebildet wird.

12. Verfahren nach einem der Patentansprüche 6 bis 11,
**dadurch gekennzeichnet, dass** in Schritt f) ein anisotropes Ätzverfahren durchgeführt wird.

13. Verfahren nach einem der Patentansprüche 6 bis 12,
**dadurch gekennzeichnet, dass** in Schritt g) eine Ionenimplantation (I) durchgeführt wird.

## Claims

1. Nonvolatile two-transistor semiconductor memory cell having
a memory transistor (ST) having a predetermined threshold voltage, which has a source and drain region (2) with a channel region lying in between in a substrate (1), a first memory transistor insulation layer (3), a charge storage layer (4), a second memory transistor insulation layer (5) and a memory transistor control layer (6) being formed at the surface of the channel region; and
a selection transistor (AT) having a predetermined threshold voltage, which has a source and drain region (2) with a channel region lying in between in the substrate (1), a first selection transistor insulation layer (3') and a selection transistor control layer (4*) being formed at the surface of the channel region, and the first selection transistor insulation layer (3') being thicker than the first memory transistor insulation layer (3), as a result of which the threshold voltages in the selection and memory transistors (AT, ST) are different,
**characterized in that**
the threshold voltages are raised by a substrate/well doping in such a way that the threshold voltage (V_{th,A}) of an evaluation circuit coincides with the threshold voltage (V_{th,UV}) of the memory transistor (ST) in the uncharged state,
the selection transistor control layer (4*) and the charge storage layer (4) in each case comprising a metallic layer, and
the selection transistor control layer (4*) having a different material layer from the charge storage layer (4) in order to correct the threshold value raising in the selection transistor (AT).

2. Nonvolatile two-transistor semiconductor memory cell according to Patent Claim 1,
**characterized in that**
the substrate (1) has a semiconductor material with a doping of the first conduction type (p).

3. Nonvolatile two-transistor semiconductor memory cell according to Patent Claim 1 or 2,
**characterized in that** the dopant concentration of the first conduction type (p) is increased in the substrate (1), the channel regions or a well region.

4. Nonvolatile two-transistor semiconductor memory cell according to one of Patent Claims 1 to 3,
**characterized in that** the first memory transistor insulation layer (3) and the first selection transistor insulation (3') have an SiO₂ layer.

5. Nonvolatile two-transistor semiconductor memory cell according to one of Patent Claims 1 to 4,
**characterized in that** the memory transistor (ST) and the selection transistor (AT) represent an NMOS and/or a PMOS transistor.

6. Method for fabricating a nonvolatile two-transistor semiconductor memory cell having the following steps:
a) formation of first insulation layers (3, 3') for a selection transistor (AT) having a predetermined threshold voltage and a memory transistor (ST) having a predetermined threshold voltage on a semiconductor substrate (1), which has a doping of the first conduction type (p), the first selection transistor insulation layer (3') being thicker than the first memory transistor insulation layer (3);
b) formation of a first metal layer (4*) at the surface of the first insulation layer (3') in a region of the selection transistor (AT) and a second metal layer (4) at the surface of the first insulation layer (3) in a region of the memory transistor (ST);
c) formation of a second insulation layer (5) at least at the surface of the second metal layer (4) in the region of the memory transistor (ST);
d) formation of a further electrically conductive layer (6) at the surface of the second insulation layer (5) at least in the region of the memory transistor (ST) ;
e) formation and patterning of a mask layer (7);
f) formation of layer stacks in the region of the selection transistor (AT) and of the memory transistor (ST) using the patterned mask layer (7); and
g) formation of source and drain regions (2) with a doping of the second conduction type (n) using the layer stack as mask, wherein
in step a) both threshold voltages in the selection and memory transistors (AT, ST) being different and by means of doping of the semiconductor substrate (1) being raised in such a way that the threshold voltage (V_{th,A}) of an evaluation circuit coincides with the threshold voltage (V_{th,UV}) of the memory transistor (ST) in the uncharged state, and
in step b) the first metal layer (4*) of the selection transistor (AT) comprising a different material from the second metal layer (4) of the memory transistor (ST) in order to correct the threshold value raising in the selection transistor (AT).

7. Method according to Patent Claim 6,
**characterized in that**, in step a), the doping of the semiconductor substrate (1) is a basic doping, well doping and/or surface doping of the first conduction type (p).

8. Method according to either of Patent Claims 6 or 7,
**characterized in that**, in step a), a tunnel oxide layer (TOX) is formed as the memory transistor insulation layer (3) and a gate oxide layer (GOX) is formed as the selection transistor insulation layer (3').

9. Method according to one of Patent Claims 6 to 8,
**characterized in that**, in step c), an ONO layer sequence is formed.

10. Method according to one of Patent Claims 6 to 9,
**characterized in that**, in step d) , a polysilicon layer is deposited, which has a doping of the second conduction type (n).

11. Method according to one of Patent Claims 6 to 10,
**characterized in that**, in step e), a hard mask layer is formed.

12. Method according to one of Patent Claims 6 to 11,
**characterized in that**, in step f), an anisotropic etching method is carried out.

13. Method according to one of Patent Claims 6 to 12,
**characterized in that**, in step g), an ion implantation (I) is carried out.

## Revendications

1. Cellule d'accumulation non volatile à semi-conducteurs à deux transistors comprenant
un transistor (ST) d'accumulation à tension à valeur de seuil définie à l'avance, qui a, dans un substrat (1), une région (2) de source et de drain avec une région de canal interposée, dans laquelle, à la surface de la région de canal, est constituée une première couche (3) isolante de transistor d'accumulation, une couche (4) d'accumulation de charges, une deuxième couche (5) isolante de transistor d'accumulation et une couche (6) de commande de transistor d'accumulation et
un transistor (AT) de sélection à tension à valeur de seuil définie à l'avance, qui a, dans le substrat (1), une région (2) de source et de drain avec une région de canal interposée, dans lequel, à la surface de la région de canal, est constituée une première couche (3') isolante de transistor de sélection et une couche (4*) de commande de transistor de sélection et la première couche (3') isolante de transistor de sélection étant plus épaisse que la première couche (3) isolante de transistor d'accumulation, de sorte que les tensions à valeur de seuil dans le transistor (AT) de sélection et dans le transistor (ST) d'accumulation sont différentes,
**caractérisée en ce que**
les tensions à valeur de seuil sont élevées par un dopage substrat/cuvette de manière à ce que, à l'état non chargé, la tension (V_{th,A}) à valeur de seuil d'un circuit d'exploitation coïncide avec la tension (V_{th,UV}) à valeur de seuil du transistor (ST) d'accumulation, dans laquelle
la couche (4*) de commande du transistor de sélection et la couche (4) d'accumulation de charges ont respectivement une couche métallique, et dans laquelle
pour corriger l'élévation de la valeur de seuil dans le transistor (AT) de sélection la couche (4*) de commande du transistor de sélection a une couche de matériau différente de la couche (4) d'accumulation de charges.

2. Cellule d'accumulation non volatile à semi-conducteurs à deux transistors suivant la revendication 1,
**caractérisée en ce que**
le substrat (1) a un matériau semi-conducteur ayant un dopage du premier type (p) de conductivité.

3. Cellule d'accumulation non volatile à semi-conducteurs à deux transistors suivant la revendication 1 ou 2,
**caractérisée en ce qu'**une augmentation de la concentration de substance de dopage du premier type (p) de conductivité a lieu dans le substrat (1), dans les régions de canal ou dans une région de cuvette.

4. Cellule d'accumulation non volatile à semi-conducteurs à deux transistors suivant l'une des revendications 1 à 3,
**caractérisée en ce que** la première couche (3) isolante du transistor d'accumulation et la première couche (3') isolante du transistor de sélection ont une couche SiO₂.

5. Cellule d'accumulation non volatile à semi-conducteurs à deux transistors suivant l'une des revendications 1 à 4,
**caractérisée en ce que** le transistor (ST) d'accumulation et le transistor (AT) de sélection constituent un transistor NMOS et/ou un transistor PMOS.

6. Procédé de fabrication d'une cellule d'accumulation non volatile à semi-conducteurs à deux transistors, comprenant les stades :
a) on forme des premières couches (3, 3') pour un transistor (AT) de sélection ayant une tension à valeur de seuil définie à l'avance et pour un transistor (ST) d'accumulation ayant une tension à valeur de seuil définie à l'avance sur un substrat (1) semi-conducteur, qui a un dopage du premier type (p) de conductivité, la première couche (3') isolante du transistor de sélection étant plus épaisse que la première couche (3) du transistor d'accumulation ;
b) on forme une première couche (4*) métallique à la surface de la première couche (3') isolante dans une région du transistor (AT) de sélection et une deuxième couche (4) métallique à la surface de la première couche (3) isolante dans une région du transistor (ST) d'accumulation ;
c) on forme une deuxième couche (5) isolante au moins à la surface de la deuxième couche (4) métallique dans la région du transistor (ST) d'accumulation ;
d) on forme une autre couche (6) conductrice de l'électricité à la surface de la deuxième couche (5) isolante au moins dans la région du transistor (ST) d'accumulation ;
e) on forme et on structure une couche (7) de masque ;
f) on forme des empilements de couches dans la région du transistor (AT) de sélection et du transistor (ST) d'accumulation en utilisant la couche (7) de masque structurée et
g) on forme des zones (2) de source et de drain par un dopage du deuxième type (n) de conductivité, en utilisant les empilements de couches comme masque, dans lequel dans le stade a), les deux tensions à valeur de seuil dans le transistor (AT) de sélection et dans le transistor (ST) d'accumulation sont différentes et sont surélevées par un dopage de substrat (1) semi-conducteur de manière à ce que la tension (V_{th,A}) à valeur de seuil d'un circuit d'exploitation coïncide à l'état non chargé avec la tension (V_{th,UV}) à valeur de seuil du transistor (ST) d'accumulation dans lequel,
dans le stade b), pour corriger l'élévation de la valeur de seuil dans le transistor (AT) de sélection, la première couche (4*) métallique du transistor (AT) de sélection a un matériau différent de celui de la deuxième couche (4) métallique du transistor (ST) d'accumulation.

7. Procédé suivant la revendication 6,
**caractérisé en ce que**, dans le stade a), le dopage du substrat (1) semi-conducteur est un dopage de base, un dopage de cuvette et/ou un dopage superficiel de premier type (p) de conductivité.

8. Procédé suivant l'une des revendications 6 ou 7,
**caractérisé en ce que**, dans le stade a), on forme, comme couche (3) isolante de transistor d'accumulation une couche (TOX) d'oxyde de tunnel et, comme couche (3') isolante de transistor de sélection, une couche (GOX) d'oxyde de grille.

9. Procédé suivant l'une des revendications 6 à 8,
**caractérisé en ce que**, dans le stade c), on forme une succession de couches ONO.

10. Procédé suivant l'une des revendications 6 à 9,
**caractérisé en ce que**, dans le stade d), on dépose une couche de polysilicium, qui a un dopage du deuxième type (n) de conductivité.

11. Procédé suivant l'une des revendications 6 à 10,
**caractérisé en ce que**, dans le stade e), on forme une couche de masque dur.

12. Procédé suivant l'une des revendications 6 à 11,
**caractérisé en ce que**, dans le stade f), on effectue un procédé d'attaque anisotrope.

13. Procédé suivant l'une des revendications 6 à 12,
**caractérisé en ce que**, dans le stade g), on effectue une implantation (I) d'ions.
